(19) Europäisches Patentamt
European Patent Office
Office européen des brevets

(11) **EP 1 887 375 B1**

(12) **EUROPÄISCHE PATENTSCHRIFT**

(45) Veröffentlichungstag und Bekanntmachung des Hinweises auf die Patenterteilung:
**11.09.2013  Patentblatt 2013/37**

(51) Int Cl.:
*G01R 33/3875* (2006.01)          *G01R 33/389* (2006.01)
*G01R 33/565* (2006.01)

(21) Anmeldenummer: **07014292.2**

(22) Anmeldetag: **20.07.2007**

(54) **Vorrichtung und Verfahren zur Kompensation von Magnetfeldstörungen in Magnetfeldern mit hoher Feldhomogenität**

Device and method for compensating magnetic field distortions in magnetic fields with high field homogeneity

Dispositif et procédé destinés à la compensation de perturbations du champ magnétique dans des champs magnétiques à forte homogénéité de champ

(84) Benannte Vertragsstaaten:
**CH DE FR GB LI**

(30) Priorität: **31.07.2006   DE 102006035949**

(43) Veröffentlichungstag der Anmeldung:
**13.02.2008   Patentblatt 2008/07**

(73) Patentinhaber: **Bruker BioSpin AG**
**8117 Fällanden (CH)**

(72) Erfinder:
• **Schenkel, Michael**
**8344 Bäretswil (CH)**

• **Hensel, Rolf**
**8008 Zürich (CH)**
• **Tschopp, Werner**
**8127 Forch (CH)**

(74) Vertreter: **Kohler Schmid Möbus**
**Patentanwälte**
**Ruppmannstraße 27**
**70565 Stuttgart (DE)**

(56) Entgegenhaltungen:
WO-A1-92/18873          DE-A1- 3 628 161
DE-A1- 10 221 640       DE-A1- 19 536 390
JP-A- 8 194 045         JP-A- 63 111 450
US-A1- 2001 013 778

**Beschreibung**

Die Erfindung betrifft eine Vorrichtung zum Kompensieren eines Störmagnetfelds in einem Elektromagneten mit hoher Feldhomogenität, insbesondere zur Stabilisierung des H0-Feldes eines MR-Messsystems, wobei das Störmagnetfeld eine periodische Feldstörung mit einer Anzahl von Störkomponenten umfasst, die jeweils eine Störfrequenz aufweisen, wobei die Vorrichtung umfasst: mindestens einen Magnetfelddetektor zum Erfassen von Störsignalen des Störmagnetfeldes, mindestens einen ersten und einen zweiten zueinander parallel geführten Regelzweig zum Bearbeiten der erfassten Störsignale, einen ersten und einen zweiten zueinander parallel geführte Regelzweig und mindestens eine Kompensationsspule, an welche die bearbeiteten Ausgangsstörsignale als Ausgangsstörsignale übertragen werden und welche ein Korrekturfeld zur Kompensation der Störsignale erzeugt.

Eine derartige Vorrichtung ist beispielsweise bekannt aus DE 295 36 390 A1, und wird insbesondere bei Kernspinresonanz (=NMR)- Spektrometer eingesetzt.

Bei derartigen Magnetanordnungen tritt bedingt durch die hohe Empfindlichkeit und Auflösung der Geräte das Problem von Feldstörungen, die durch Zusatzgeräte am Spektrometer, durch Anlagen und Maschinen, die zur Gebäudeinstallation gehören (Fahrstühle, Kompressoren, etc), oder durch externe Störquellen (Straβenbahnen, etc) entstehen, immer stärker in den Vordergrund.

Eine Feldänderung $(\Delta B)_z$ parallel zum statischen Magnetfeld $B_0$ des NMR-Magneten und im Bereich der NMR-Messsubstanz erzeugt eine zu ihr proportionale Änderung $\Delta\omega$ der Resonanzfrequenz der magnetischen Kernspins innerhalb der Messsubstanz und dadurch eine Beeinflussung des NMR-Spektrums. Dies kommt in der bekannten NMR-Gleichung $\Delta\omega = \gamma \cdot (\Delta B)_z$ zum Ausdruck. Infolge der hohen spektralen Auflösung sowie der hohen Empfindlichkeit heutiger NMR-Spektrometer machen sich im NMR-Spektrum bereits kleinste Störfelder von weniger als $1.10^{-9}$ Tesla störend bemerkbar.

Aufgrund von inzwischen erzielten enormen Fortschritte bei der Steigerung der NMR- Empfindlichkeit mittels höherer Magnetfeldstärke, der Verbesserung der Feldhomogenität innerhalb größeren Messräumen und den Einsatz von um Faktoren empfindlicheren kryogen gekühlten Messsonden (=Kryoproben) , ist es bislang nicht möglich sämtliche relevanten Feldstörungen zu kompensieren.

Einer dieser bisher ungelösten Fälle betrifft den Einsatz von Refrigeratoren zur Kühlung von supraleitenden NMR-Magneten. Die unvermeidlichen, niederfrequenten Vibrationen solcher Systeme führen zu Magnetfeldmodulationen, welche sich im Spektrum als Seitenbänder von starken NMR-Linien manifestieren. Diese Seitenbänder liegen häufig im empfindlichsten Bereich des NMR-Spektrums (im Zentrum, im Bereich der Wasserlinie, etc.) und sind daher für den Anwender sehr störend.

DE 36 28 161 A1 beschreibt einen supraleitenden Magneten in einem Kryostaten, auf dem ein Refrigerator zur Kühlung der kryogenen Flüssigkeiten montiert ist. Mit einer Sensoreinrichtung, die am Refrigerator montiert ist, wird das vom Refrigerator herrührende Störsignal mit Induktionsspulen oder Beschleunigungssensoren erfasst und über ein Steuergerät den Kompensationsspulen zugeführt. Letztere werden vorzugsweise am Refrigerator und/oder in der Raumtemperatur-Bohrung (= RT-Bohrung) des Magneten montiert. Das Steuergerät enthält eine Koppelmatrix mit einstellbaren Verstärkungen (zum "wichten") sowie ein Kennlinienfeld. Die Erfahrung zeigt aber, dass aus der Messung an der Störquelle nur unzureichend auf die Magnetfeldstörungen im Probenvolumen geschlossen werden kann.

US 5,191,287 A1 zeigt, wie die im inhomogenen $B_0$-Feld rotierende Messprobe periodische Feldstörungen in den magnetischen Spins der Messprobe erzeugt, wodurch störende Seitenbänder im NMR-Signal entstehen. Diese werden jedoch nicht direkt kompensiert, sonder erst nachträglich im NMR-Empfänger, indem das NMR-Signal eine zweite manuell abstimmbare Amplituden- und Phasenmodulation erfährt, die zusätzliche Seitenbänder erzeugt, mit denen die bereits vorhandenen störenden Seitenbänder kompensiert werden. Die benötigten Hilfsfrequenzen für die Modulatoren werden mit Hilfe von Frequenzgeneratoren erzeugt, die mit der rotierenden Messprobe synchronisiert sind. Hier handelt es sich also um einen Kompensations- aber nicht um einen Regelvorgang, da kein Regelkreis vorhanden ist. Da der Spektroskopiker den Verlauf einer NMR-Messung weitgehend frei programmieren kann ist eine Kompensation a posteriori nicht oder nur mit extremem Aufwand machbar.

Ein weiterer Fall sind Störungen, die durch den Einsatz von NMR Systemen in nicht optimaler Umgebung entstehen, weil immer weniger Kunden bereit sind, teure und aufwändige Infrastrukturen (Gebäude, Räume, etc.) zu finanzieren. Als Beispiel seien hier Bodenvibrationen erwähnt, die durch im selben Gebäude befindliche Anlagen verursacht werden.

In US 4,788,502 A1 werden Störfelder aus weit entfernten Quellen (z.B. Straßenbahnen) mit Hilfe von Induktionsspulen empfangen und über einen Regelverstärker den Kompensationsspulen gegensinnig zugeführt, so dass eine Gegenkopplung der Störfelder erreicht wird. Die Induktions- und Kompensationsspulen befinden sich vorwiegend außerhalb des NMR-Magnetsystems und umfassen diesen. Dieses Verfahren scheidet jedoch aus, wenn die Störungen durch mechanische Vibrationen in das Magnetsystem eingekoppelt werden.

Aus US 5, 302899 A1, ist ein Verfahren zur Kompensation von zeitvarianten Feldstörungen in der NMR bekannt, bei welchem mit Hilfe eines digitalen NMR- Feldstabilisators (= digitaler Lock) das NMR- Dispersionssignal $u_x$ sowie

das NMR- Absorptionssignal uy einer NMR- Bezugsubstanz (= Locksubstanz) aufgenommen und daraus ein Korrekturstrom abgeleitet wird, der in eine Feldkorrekturspule geleitet wird und dazu dient, die zeitvarianten Feldstörungen zu kompensieren. Hierbei wird eine Kombination der Größen $u_x/u_y$ und $1/u_y \cdot (du_x/dt)$ einem Regler mit einfach und/ oder doppelt integrierendem Verstärker zugeführt. Dadurch entsteht im Wesentlichen ein PID- Regler auf die Messgröße $u_x/u_y$, der bei geeigneter Einstellung der Regler- Parameter die Feldstörungen hinreichend kompensiert. Eine befriedigende Einstellung der Regler- Parameter ist aber bei Störungen mit höheren Frequenzkomponenten oftmals unmöglich. Wird die Verstärkung des Reglers klein gewählt, entsteht zwar ein kleinerer Rauschanteil aber gleichzeitig wird auch die Regelbandbreite kleiner und dadurch die Störunterdrückung der höheren Frequenzkomponenten ungenügend. Umgekehrt erreicht man durch eine Erhöhung der Verstärkung zwar eine größere Regelbandbreite, so dass eine bessere Störunterdrückung zu erwarten wäre, aber gleichzeitig steigt auch der Rauschanteil an und verunmöglicht dadurch ein befriedigendes Resultat.

DE 295 36 390 A1 offenbart eine Anordnung zur Regelung des grundfeldes eines Magneten eines Kernspintomografen, bei dem Störfelder aus weit entfernten Quellen mithilfe zweier Sonden empfangen werden. Jede Sonde befindet sch in einem Regelkreis, in dem niederfrequente Signalanteile ausgefiltert werden und einer Kompensationsspule gegensinnig zugeführt werden, so dass eine Gegenkopplung der Störfelder erreicht wird.

In JP 08194045 wird die Verwendung eines NMR-Lock-Regelkreises zur Unterdrückung von Rauschsignalen beschrieben.

Aufgabe der vorliegenden Erfindung ist es daher, eine Vorrichtung und ein Verfahren zur Kompensation von Störfeldern vorzuschlagen, wobei neben einem hohem Signal/Rausch-Verhältnis (=SINO) eine Verbesserung der Kompensation von periodischen Feldstörungen, insbesondere mit höheren Frequenzkomponenten gewährleistet wird.

Diese Aufgabe wird erfindungsgemäß durch eine Vorrichtung gemäß Anspruch 1 und ein Verfahren gemäß Anspruch 13 gelöst.

Bei der erfindungsgemäßen Vorrichtung umfasst mindestens einer der Regelkreise ein multiselektives Filtersystem (=MSF), welches ein oder mehrere parallel geschaltete selektive Filterelemente aufweist, deren Mittelfrequenzen entweder einmalig oder adaptiv auf die Frequenzwerte der zu kompensierenden Störsignale abstimmbar sind, wobei die Ausgänge dieser Filterelemente mit mindestens einer der Kompensationsspulen verbunden sind.

Bei der erfindungsgemäßen Vorrichtung können die Ausgangsignale der Filterelemente des MSF entweder einzeln oder nach deren Addition und unter Einhaltung der Stabilitätskriterien von Regelkreisen verstärkt, und ev. Phasen korrigiert werden, um dann der Kompensationsspule zugeführt zu werden, die ein der Störung entgegen gesetztes Magnetfeld erzeugt. Die erfindungsgemäße Vorrichtung wirkt somit als Feldstabilisator, mit dem innerhalb beispielsweise einer MR-Apparatur periodische Feldstörungen mit höheren Frequenzkomponenten selektiv erfasst werden können, so dass nur ein Bruchteil des vorhandenen Rauschens erfasst wird. Hierdurch wird eine Verbesserung des SINO bewirkt, so dass insbesondere periodische Störsignale mit hohen Frequenzen besser unterdrückt werden können.

Die erfindungsgemäße Vorrichtung umfasst mehrere Regelkreise, von denen mindestens einer ein MSF enthält, wobei die Mittelfrequenzen der MSFs entweder einmalig oder adaptiv auf die Frequenzwerte der zu kompensierenden Störsignale abgestimmt werden. Darüber hinaus ist ein konventioneller Regelkreis mit einem Regelverstärker vorgesehen, mit dem zusätzlich zu der erfindungsgemäßen selektiven Kompensation, insbesondere im niederfrequenten Bereich, eine breitbandige Feldstörungskompensation erreicht werden kann.

Bei Verwendung von mehreren MSFs sind diese in verschiedenen Regelkreisen der erfindungsgemäßen Vorrichtung angeordnet. Dabei besteht die Möglichkeit entweder sämtliche MSFs durch einen einzigen Magnetfelddetektor mit Signalen zu versorgen, oder aber für zumindest einen Teil der verschiedenen MSFs separate Magnetfelddetektoren und entsprechend auch separate Kompensationsspulen vorzusehen, so dass die MSFs in voneinander unabhängigen Systemen integriert sind.

Vorzugsweise ist ein Additionsglied zum Addieren der Ausgangsstörsignale der Filterelemente vorgesehen.

Eine vorteilhafte Ausführungsform der erfindungsgemäßen Vorrichtung sieht vor, dass mindestens eines der multiselektiven Filterelemente ein Bandpassfilter zweiter Ordnung mit der komplexen Übertragungsfunktion $U_{BP}(j\omega)$ ist, wobei gilt:

$$U_{BP}(j\omega) = 1 / ( 1 + j \cdot Q \cdot \Omega ),$$

mit

$$j = \sqrt{-1}$$

$Q \approx \omega_0/B$

$\omega_0$ = Mittelfrequenz des Bandpassfilters

B = -3db Bandbreite des Bandpassfilters

$\Omega$ - $(\omega/\omega_0)$ - $(\omega_0/\omega)$

$\Omega \approx 2\cdot(\omega - \omega_0) / \omega_0$ wenn $(\omega - \omega_0) / \omega_0 \ll 1$

$\omega$ = Frequenzwert auf der Frequenzachse

Bei einer Weiterbildung dieser Ausführungsform besitzt das selektive Filterelement einen Regler, mit dem die Mittelfrequenz des Bandpassfilters auf die Frequenz eines der Störsignale geregelt wird, wobei der Regler einen in seiner Frequenz einstellbaren Frequenzgenerator, einen Phasendetektor zur Detektion des Ausgangssignals des Frequenzgenerators und des Ausgangssignals aus dem Bandpassfilter, einen Verstärker und einem dem Verstärker nachgeschalteten Tiefpassfilter umfasst, wobei das resultierende Detektionssignal aus dem Phasendetektor über den Verstärker und den Tiefpassfilter einem Register zugeführt wird, der mit seinem Zahlenwert die Frequenz des Frequenzgenerators definiert und den Ausgangswert des Reglers darstellt.

Eine alternative Ausführungsform sieht vor, dass mindestens eines der multiselektiven Filterelemente einen Quadraturdetektor umfasst, in den das Störsignal sowie zwei Referenzsignale über zwei Signalkanäle eingespeist werden, wobei die Frequenz der Referenzsignale ungefähr gleich der Frequenz des Störsignals ist, wobei die Phasen der Referenzsignale um 90° zueinander gedreht sind. Darüber hinaus ist eine Übertragungseinheit vorgesehen, die zu einem Quadraturmodulator mit einem Additionsglied führt, in dem die in den Signalkanälen über die Übertragungseinheit zum Quadraturmodulator geleiteten Störsignale addiert werden, wobei die Referenzsignale im Quadraturmodulator identisch mit den Referenzsignalen im Quadraturdetektor sind. Durch die 90°-Drehung der Phasen der Referenzsignale zueinander erscheint in den beiden Signalkanälen am Ausgang des Quadraturdetektors je ein Störsignal auf einer sehr viel tieferen Frequenz und mit einer um 90° zueinander verschobenen Phase, die nach Durchlaufen der Übertragungseinheit im Quadraturmodulator zu einem Ausgangsstörsignal addiert werden. Nach dieser Addition erscheint das Ausgangsstörsignal mit seiner ursprünglichen Frequenz, jedoch im Gegensatz zum ursprünglichen Störsignal ist dieses Ausgangsstörsignal gefiltert, wobei der Filtervorgang dem eines Bandpassfilters entspricht, dessen Bandbreite gleich der doppelten Grenzfrequenz des Tiefpassfilters in der Übertragungseinheit ist.

Vorzugsweise umfasst die Übertragungseinheit für jeden Signalkanal jeweils einen Verstärker und einen Tiefpassfilter.

Dabei besitzt der Tiefpassfilter vorzugsweise eine komplexe Übertragungsfunktion $U_{TP}$ (j$\omega$) , die wie folgt definiert ist:

$$U_{TP}(j\omega) = 1/[1 + j(\omega/\omega_C)],$$

wobei

$$j = \sqrt{-1}$$

$\omega$ = Frequenzwert auf der Frequenzachse

$\omega_c$ = Grenzfrequenz des Tiefpassfilters

Dieses Tiefpassfilter erster Ordnung erzeugt niemals mehr als 90 Grad Phasendrehung.

Alternativ hierzu kann die Übertragungseinheit für jeden Signalkanal (A, B) jeweils einen Verstärker und einen Integrator umfassen. Da die Verstärkung eines Integrators für die Frequenz Null gegen unendlich geht, werden Störsignale mit identischer Frequenz wie die Referenzsignale ohne Restfehler kompensiert.

Eine besonders bevorzugte Ausführungsform der erfindungsgemäßen Vorrichtung sieht am Ausgang des Quadraturdetektors ein Regler vor, über den eines der beiden durch den Quadraturdetektor transformierten Störsignale aus einem der beiden Signalkanäle erfasst und einem Referenzgenerator zugeführt werden kann, wobei der Regler vorzugsweise einen Verstärker und einen Tiefpassfilter umfasst.

Insbesondere bei großen Verstärkungswerten ist es vorteilhaft, wenn am Eingang des Quadraturmodulators ein Phasenschieber vorgesehen ist, der die beiden zueinander orthogonalen Signale in den beiden Signalkanälen um einen bestimmten Winkel $\Delta\varphi$ verschiebt, so dass das Ausgangsstörsignal des selektiven Filterelements zusätzlich zum Phasengang der Übertragungseinheit um den konstanten Winkel $\Delta\varphi$ gegenüber dem Störsignal verschoben ist. Auf diese Weise können ungewollte Oszillationen vermieden werden.

Bei einer vorteilhaften Weiterbildung dieser Ausführungsform ist vor oder nach dem Phasenschieber ein Abtast-Halteglied geschaltet, welches synchron zum Referenzgenerator betrieben wird. Hierdurch wird das obere Seitenband, welches im Quadraturdetektor ebenfalls entsteht und durch das Tiefpassfilter nicht vollständig unterdrückt wird, auf das untere Seitenband gefaltet, wo es nicht mehr stört.

Besonders vorteilhaft ist es, wenn bei mindestens einem der selektiven Filterelemente ein Steuereingang vorgesehen ist, über den die Güte des selektiven Filterelements vorübergehend auf sehr hohe Werte umschaltbar ist. Auf diese Weise wird der Bandpassfilter unempfindlich auf das Eingangssignal gemacht. Eine Erhöhung der Güte des selektiven Filterelements ist z.B. dann nützlich, wenn bei einem NMR-Spektrometer das Probengläschen gewechselt wird und dadurch das Signal $U_{in}$ starken Schwankungen unterworfen ist.

Die Vorteile der Erfindung kommen besonders bei hochempfindlichen Magnetanordnungen gut zur Geltung. Die erfindungsgemäße Vorrichtung ist daher Teil einer NMR-Apparatur, vorzugsweise wenn zur Kühlung der supraleitenden Magneten Refrigeratoren eingesetzt werden, da diese periodische Störungen im Untersuchungsvolumen hervorrufen, welche mit Hilfe der erfindungsgemäßen Vorrichtung effektiv kompensiert werden.

Die Erfindung betrifft auch ein Verfahren zum Kompensieren von Feldstörungen in Magnetfeldern von Elektromagneten mit hoher Feldhomogenität, insbesondere zur Stabilisierung des H0-Feldes eines NMR-Messsystems, wobei Störsignale mittels eines Magnetfelddetektors erfasst und diese über einen Regelzweig an eine Kompensationsspule übergeben werden, die ein Korrekturfeld zur Kompensation der Feldstörungen erzeugt. Bei dem erfindungsgemäßen Verfahren werden die Störsignale durch parallel geschaltete selektive Filterelemente eines multiselektives Filtersystems geleitet, wobei eine einmalige oder adaptive Abstimmung der Mittelfrequenzen der selektive Filterelemente auf die Frequenzwerte der zu kompensierenden Störsignale erfolgt. Darüber hinaus sieht das erfindungsgemäße Verfahren vor, dass die Ausgangsignale dieser Filterelemente vor Übergabe an die Kompensationsspule entweder einzeln oder nach deren Addition und unter Einhaltung der Stabilitätskriterien von Regelkreisen verstärkt und bei Bedarf phasenkorrigiert werden.

Bei einer vorteilhaften Variante des erfindungsgemäßen Verfahrens wird die Mittelfrequenz eines als Bandpassfilter ausgebildeten selektiven Filterelements mittels eines Reglers der Frequenz des Störsignals nachgeführt, wobei das Ausgangssignal eines in seiner Frequenz einstellbaren Frequenzgenerators, sowie das Ausgangsstörsignal aus dem Bandpassfilter in einem Phasendetektor detektiert werden, und anschließend das resultierende Detektionssignal über einen Verstärker und einen Tiefpassfilter geleitet und einem Register zugeführt wird, der mit seinem Zahlenwert die Frequenz des Frequenzgenerators definiert, wobei dieser Zahlenwert dazu benutzt wird, die Mittelfrequenz des Bandpassfilters auf die Frequenz des Störsignals einzustellen. Das selektive Filterelement kann hierbei ein direkt gerechnetes Bandpassfilter zweiter Ordnung sein.

Eine alternative Variante sieht vor, dass innerhalb eines Filterelements das Störsignal sowie zwei Referenzsignale eines Referenzgenerators in einen Quadraturdetektor eingespeist werden, wobei die Frequenz dieser Referenzsignale ungefähr gleich der Frequenz des Störsignals ist und deren Phasen um 90° zueinander gedreht sind, wodurch in den beiden Signalkanälen am Ausgang des Quadraturdetektors je ein Störsignal auf einer sehr viel tieferen Frequenz und mit einer um 90° zueinander verschobenen Phase erzeugt wird, wobei diese zwei Störsignale jeweils über einen Verstärker und einen Tiefpassfilter geleitet und einem Quadraturmodulator zugeführt werden, dessen Referenzsignale identisch mit denen des Quadraturdetektors sind. Nach Addition der beiden Störsignale im Quadraturmodulator liegt somit ein Ausgangsstörsignal mit der ursprünglichen Frequenz des Störsignals vor, wobei jedoch das Ausgangsstörsignal im Gegensatz zum ursprünglichen Störsignal gefiltert ist.

Bei einer Weiterbildung dieser Variante wird, vorzugsweise am Ausgang des Quadraturdetektors, eines der beiden Störsignale in den Signalkanälen erfasst und über einen Regler dem Referenzgenerator zugeführt, wobei die Frequenz des Referenzgenerators möglichst genau auf die Frequenz des Störsignals eingestellt wird (= adaptiver Vorgang). Auf diese Weise kann auf Frequenzänderungen der Störsignale schnell und effektiv reagiert werden.

Vorzugsweise werden die beiden orthogonalen Signale in den Signalkanälen mittels eines Phasenschiebers am Eingang des Quadraturmodulators um einen bestimmten Winkel $\Delta\varphi$ verschoben.

Hierbei ist es von Vorteil, wenn vor oder nach dem Phasenschieber ein Abtast-Halteglied geschaltet wird, welches synchron zum Referenzgenerator betrieben wird.

Darüber hinaus kann es vorteilhaft sein, wenn die Güte der selektiven Filterelemente durch einen Steuereingang (Hold) vorübergehend auf sehr hohe Werte umgeschaltet wird.

Weitere Vorteile der Erfindung ergeben sich aus der Beschreibung und der Zeichnung. Die gezeigten und beschriebenen Ausführungsformen sind nicht als abschließende Aufzählung zu verstehen, sondern haben vielmehr beispielhaften Charakter für die Schilderung der Erfindung.

Es zeigen

Fig. 1     ein Blockschaltbild einer erfindungsgemäßen Vorrichtung mit zwei Regelkreisen;

Fig. 2a     Störkomponenten sowie ein breitbandiges Rauschen eines Magnetfelddetektors;

Fig. 2b     Störkomponenten und das Rauschband am Ausgang eines konventionellen Regelverstärkers, dessen Frequenzgang Tiefpasscharakter besitzt;

Fig. 3a     Störkomponenten sowie ein breitbandiges Rauschen eines Magnetfelddetektors;

Fig. 3b    durch selektive Filterelemente gefilterte periodische Störkomponenten;

Fig. 3c    den Anteil des gesamten breitbandigen Rauschens, der durch die selektiven Filterelemente gelangt;

Fig. 4    eine erfindungsgemäße Ausführungsform eines MSF mit einem selektiven Filterelement in Form eines digitales Bandpassfilters; und

Fig. 5    eine weitere erfindungsgemäße Ausführungsform eines MSF mit einem selektiven Filterelement in Form eines Quadraturdetektors.

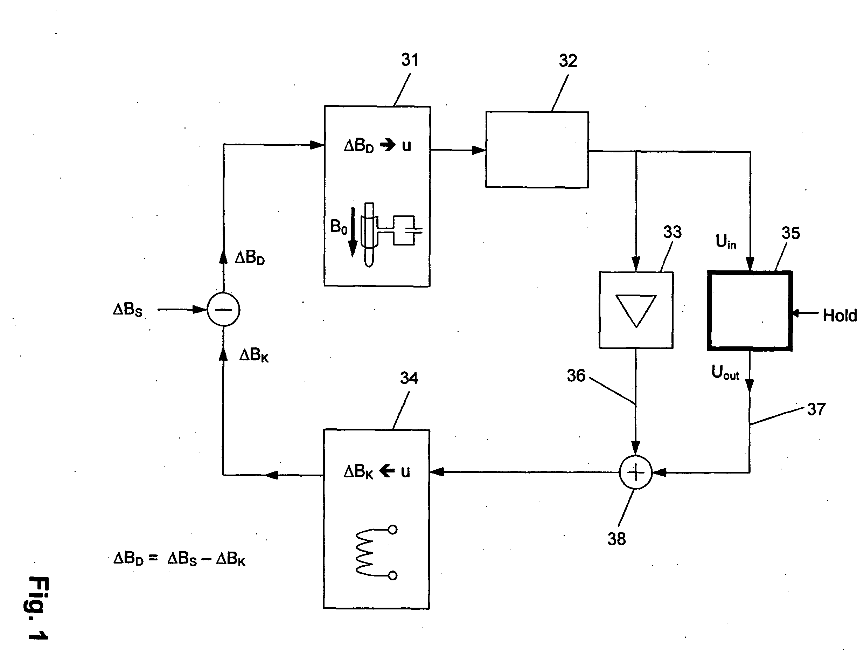

**Fig. 1** zeigt eine Vorrichtung (Feldstabilisator) zum Kompensieren von Feldstörungen in Magnetfeldern, beispielsweise zur Verwendung in einer MR-Apparatur. Zur Detektion von Störsignalen $U_{in}$ eines Störfelds $\Delta B_S$ ist ein Magnetfelddetektor 31 vorgesehen. Der Magnetfelddetektor 31 gehört zu einem "NMR-Lock" und enthält eine NMR-Messprobe in einem HF-Resonator, der sein Ausgangssignal an einen NMR-Empfänger **32** und anschließend an zwei parallel geführte Regelzweige **36, 37** weiter gibt. Der erste Regelzweig 36 umfasst einen Regelverstärker **33**. Ein derartiger Regelkreis ist bereits aus dem Stand der Technik bekannt und ist in erster Linie für die Unterdrückung der langsamen Feldänderungen verantwortlich. Im zweiten Regelzweig 37 ist ein multiselektives Filtersystem **35** angeordnet, das hauptsächlich die periodischen Feldstörungen unterdrücken soll. Die Signale beider Regelzweige 36, 37 werden in einem Additionsglied **38** addiert und einer Kompensationsspule **34** zugeführt. Am Ausgang der Kompensationsspule 34 wird ein Korrekturfeld $\Delta B_K$ erzeugt, mit dem das eigentliche Störfeld $\Delta B_S$ kompensiert wird, so dass nur noch ein kleiner Differenzanteil $\Delta B_D = \Delta B_S - \Delta B_K$ in den Magnetfelddetektor 31 gelangt und damit den ganzen Regelkreis schließt.

Das zentrale Element der erfindungsgemäßen Vorrichtung ist das MSF 35, das für jede periodische Störkomponente, die unterdrückt werden soll, je ein selektives Filterelement zur Verfügung stellt, wobei alle Filterelemente parallel zueinander liegen und zu dem separaten Regelzweig 37 innerhalb des gesamten Feldstabilisators zusammengefasst sind. Die einzelnen Filterelemente übertragen selektive Frequenzbereiche, deren Mittelfrequenzen auf die einzelnen Störfrequenzen $U_{in}$ eingestellt sind. Entweder erfolgt diese Einstellung vor der Inbetriebnahme des Feldstabilisators und bleibt während des ganzen Regelvorganges unverändert, oder sie erfolgt kontinuierlich und automatisch während des ganzen Regelvorganges (adaptives Vorgehen).

Um den Nutzen des MSF 35 besser zu verstehen, soll zunächst das Regelverhalten des konventionellen Feldstabilisators 33 erläutert werden:

Mit zunehmender Regelverstärkung nehmen bei dem Feldstabilisators 33 die Regelbandbreite und damit die Güte der Feldstabilisierung zu. Dies gilt bis zu dem Punkt, an dem der Regelkreis instabil zu werden beginnt, oder an dem der steigende Rauschanteil im Regelsystem so groß wird, dass die Güte der Feldstabilisierung wieder abnimmt. Dieser Punkt definiert die nutzbare Regelbandbreite.

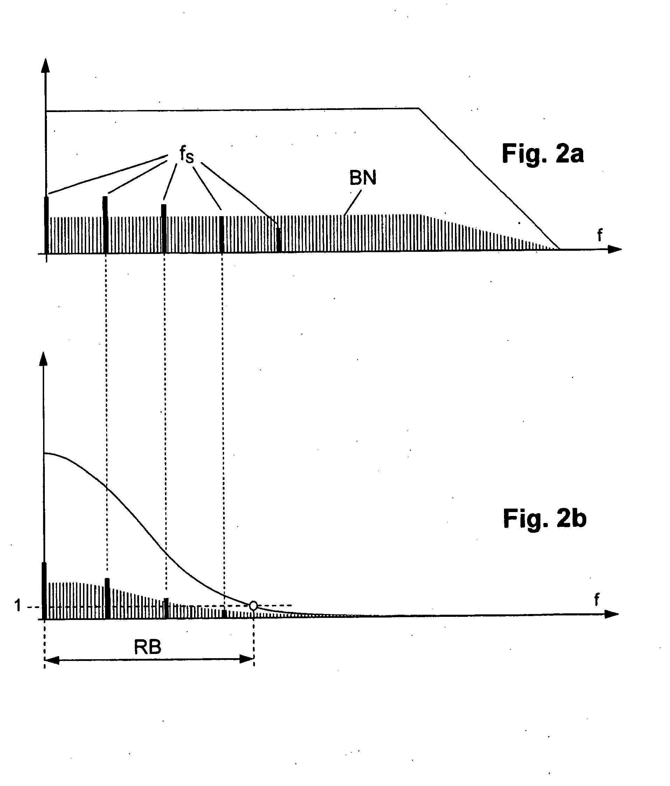

**Fig. 2a** zeigt anhand eines Beispiels die Signale, die in einem Feldstabilisator auftreten können, und zwar am Ausgang des Magnetfelddetektors 31. Es ist ein breitbandiges Rauschen **BN** zu erkennen sowie diverse Störkomponenten **$f_s$,** die unterdrückt werden sollen. Mit der Störkomponente der Frequenz f = 0 (= DC-Störsignal) können die langsamen Feldänderungen unterdrückt werden. Es sind auch vier periodische Störkomponenten höherer Frequenz erkennbar, die in diesem Beispiel als Harmonische einer Grundfrequenz zu betrachten sind.

**Fig. 2b** zeigt die Störkomponenten $f_S$ und das Rauschband am Ausgang des Regelverstärkers 33, dessen Frequenzgang Tiefpasscharakter besitzt. Die eingezeichnete Funktionskurve stellt den Amplitudengang des offenen Regelkreises dar. Die Frequenz, bei der diese Kurve die Verstärkung 1 (= 0 db) besitzt, definiert die Regelbandbreite **RB**. Das DC-Signal bei f = 0 erfährt die höchste Regelverstärkung und damit die beste Unterdrückung. Die periodischen Störkomponenten $f_S$, die innerhalb der Regelbandbreite liegen, werden auch unterdrückt. Je näher diese jedoch am hochfrequenten Ende der Regelbandbreite RB liegen, desto kleiner ist ihre Unterdrückung. Periodische Störkomponenten, die außerhalb der Regelbandbreite RB liegen, werden nur unwesentlich unterdrückt.

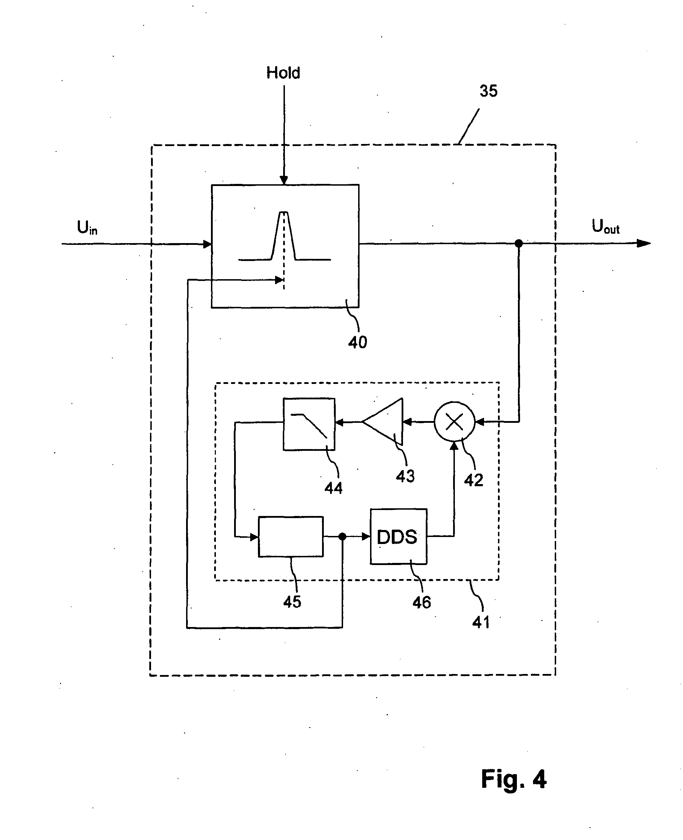

Mit der erfindungsgemäßen Vorrichtung können durch Verwendung des MSF 35 die einzelnen periodischen Störkomponenten $f_S$ mit einem besseren SINO erfasst werden, so dass die Regelverstärkung für diese Störkomponenten $f_S$ erhöht und eine größere nutzbare Regelbandbreite und somit die Unterdrückung der Störkomponenten $f_S$ erreicht werden kann. Dabei müssen regeltechnische Stabilitätskriterien beachtet werden, die aber nicht problematisch sind, wenn die Flanken der selektiven Bereiche des MSF 35 nicht zu steil gewählt werden. Dies kann z.B. dadurch erreicht werden, dass für die Frequenzselektion innerhalb des MSF 35 ein Bandfüter **40** zweiter Ordnung gewählt wird **(Fig. 4).** Die beiden Flanken des Bandfilters 40 definieren die Grenzen der Regelbandbreite. Wenn diese sehr steil sind, erzeugen sie an den beiden Grenzen starke Phasendrehungen und dadurch große Gruppenlaufzeiten, welche Instabilitäten im geschlossenen Regelkreis hervorrufen können. Gute Resultate erreicht man, wenn die gesamte Phasendrehung an den beiden Grenzen der Regelbandbreite nicht mehr als ca. +90° resp. -90° beträgt.

Ein Bandfilter 40 zweiter Ordnung besitzt die komplexe Übertragungsfunktion $U_{BP}(j\omega)$, die wie folgt definiert ist:

$$U_{BP}(j\omega) = 1 / (\ 1 + j \cdot Q \cdot \Omega\ )$$

wobei

$$j = \sqrt{-1}$$

$Q \approx \omega_0 / B$

$\omega_0$ = Mittelfrequenz des Bandpassfilters

B = -3db Bandbreite des Bandpassfilters

$\Omega = (\omega/\omega_0) - (\omega_0/\omega)$

$\Omega \approx 2 \cdot (\omega - \omega_0) / \omega_0$ wenn $(\omega - \omega_0) / \omega_0 << 1$

$\omega$ = Frequenzwert auf der Frequenzachse

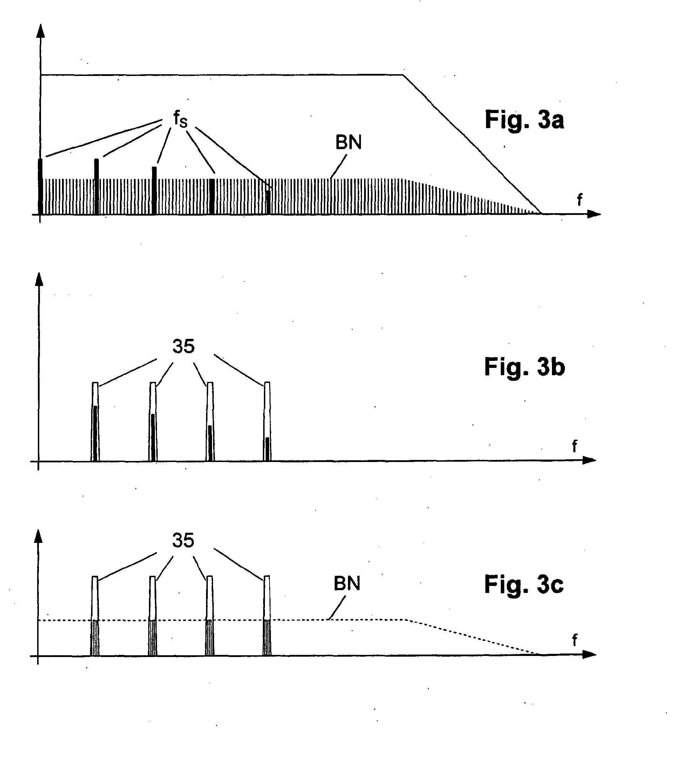

Aus **Fig. 3a -c** werden die Vorteile bei der Verwendung eines MSF 35 deutlich. Fig. 3a zeigt das Signal aus dem Magnetfelddetektor 31 und setzt sich aus den einzelnen störenden Frequenzkomponenten $f_S$ sowie dem breitbandigen Rauschen BN zusammen. Die DC-Komponente bei f = 0 ist für die langsamen Änderungen des Feldes verantwortlich. Die übrigen vier Frequenzkomponenten $f_s$ stellen die periodischen Störsignale dar, die mit Hilfe des MSF 35 stärker unterdrückt werden sollen. Fig. 3b zeigt wie die einzelnen periodischen Störkomponenten durch das MSF 35 gelangen. Aus Fig. 3c wird ersichtlich, dass nur ein kleiner Teil des Gesamtrauschens BN vom MSF 35 durchgelassen wird. Das Störsignal am Ausgang des MSF 35 lässt sich deshalb mit einem hohen SINO erfassen und deshalb auch optimal mit der erfindungsgemäßen Vorrichtung unterdrücken.

Wenn als Magnetfelddetektor 31 eine NMR-Messprobe in einem HF-Resonator verwendet wird, der sein Ausgangssignal an den NMR-Empfänger 32 weitergibt (= NMR-Lock wie in Fig. 1 gezeigt), dann muss beachtet werden, dass infolge der Eigenschaften der magnetischen Spins in der NMR-Messprobe der Magnetfelddetektor 31 einem selektiven "Bandpassfilter" sehr hoher Güte mit einer Bandbreite von z.B. nur 0.1 Hz entspricht. Die Übertragungseigenschaften dieses "Bandpassfilters" können einen starken Einfluss auf die Stabilität des Regelkreises ausüben, indem an der oberen Frequenzgrenze des Regelbereichs der Flankenbereich dieses "Bandpassfilters" maßgebend ist. Dieser kann eine 90°-Drehung des Magnetfelddetektorsignals verursachen. Da die einzelnen selektiven Filterelemente des MSF 35 ebenfalls eine Phasendrehung von ca. 90° an diesem Ort erzeugen können, muss aus regeltechnischen Gründen die so entstehenden ca. 180° mit einem im Regelkreis eingebauten Phasenkorrekturglied auf ca. 90° reduziert werden.

**Fig. 4** zeigt ein selektives Filterelement innerhalb eines MSF 35, das als digitaler Bandpassfilter **40** realisiert ist. Der Bandpassfilter 40 weist eine hohe Güte auf und besitzt einen Regler **41**, der einen in seiner Frequenz einstellbaren Frequenzgenerator **46** umfasst. Der Regler 41 hat die Aufgabe, die Frequenz des Frequenzgenerators 46 auf die Frequenz des Störsignals $U_{in}$ einzustellen, d.h. der Regler arbeitet sozusagen als Frequenzmesser, wobei der Zahlenwert, der die Frequenz des Frequenzgenerators definiert, den Messwert darstellt. Mit diesem Messwert lässt sich die Mittelfrequenz des Bandfilters 40 direkt korrigieren.

Als Regler 41 eignet sich insbesondere ein Phase Locked Loop (PLL). Dieser regelt die Frequenz einer synthetischen Sinusschwingung so, dass diese eine starre Phasenbeziehung zum Signal $U_{out}$ hat. Mit Hilfe des PLL wird die Frequenz des Frequenzgenerators 46 auf die Ausgangsfrequenz des Bandpassfilters 40 geregelt und der Frequenzwert des Frequenzgenerators 46 dazu benutzt, die Mittelfrequenz des Bandpassfilters 40 einzustellen. Dabei wird das Ausgangssignal des Frequenzgenerators 46 genauso wie das Signal $U_{out}$ aus dem Bandpassfilter 40 in einem Phasendetektor **42** detektiert. Das resultierende Detektionssignal wird anschließend über einen Verstärker **43** und einen Tiefpassfilter **44** geleitet und einem Register **45** zugeführt, der mit seinem Zahlenwert wiederum die Frequenz des Frequenzgenerators 46 definiert.

Mit dem Eingang **Hold** kann ein Haltevorgang gestartet werden, der den Bandpassfilter möglichst unempfindlich auf das Eingangssignal (Störsignal $U_{in}$) machen soll. Der Haltevorgang dient dazu, während eines absichtlich verursachten Störvorganges (z.B. Wechsel der NMR-Probe) den Betriebszustand des selektiven Filterelementes solange festzuhalten, bis der Haltevorgang wieder deaktiviert wird. Erreicht wird dies indem der Gütewert (= Q-Wert) des Bandpassfilters während des Haltevorganges sehr groß gemacht wird, so dass die Bandbreite sehr klein wird, und die Ein- und Ausschwingzeiten des Bandfilters 40 sehr groß werden. Der erforderliche Q-Wert richtet sich nach der Dauer des gewünschten Haltevorganges und wird so gewählt, dass die Ein- und Ausschwingzeiten sehr viel größer als die Dauer des Haltevorganges sind. Der Bandpassfilter 40 reagiert dadurch sehr träge auf Änderungen des Störsignals $U_{in}$ und ist nach Beendigung des Haltevorganges und nachdem der Q-Wert wieder auf den ursprünglichen Wert gesetzt wurde, sehr viel schneller funktionsbereit, da er sich bereits in einem angenähert eingeschwungenen Zustand befindet.

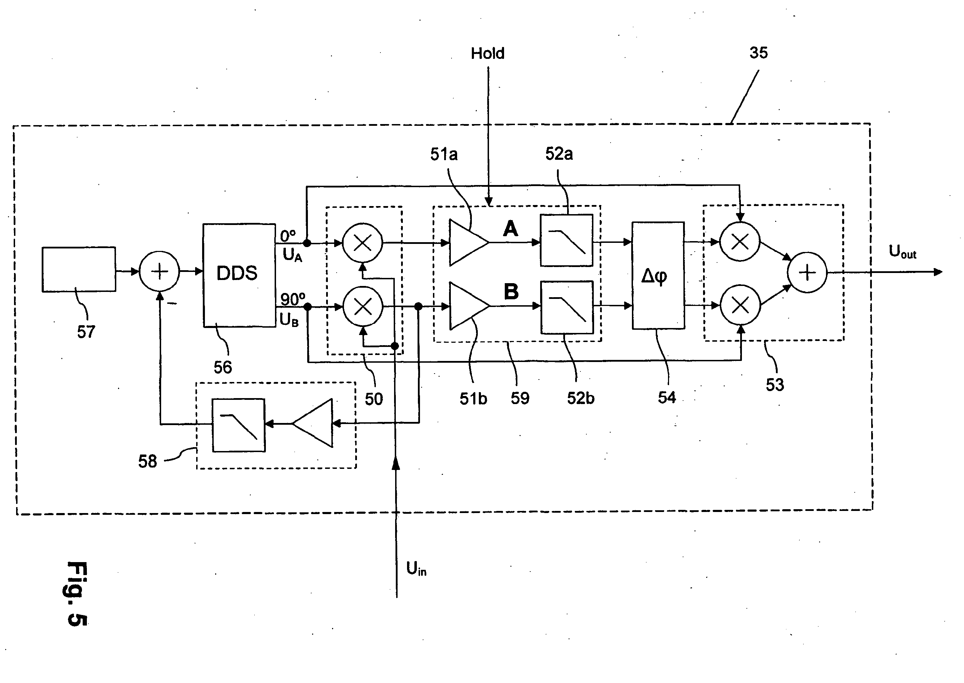

Die Realisierung von Bandpassfiltern 40 sehr hoher Güte kann rechentechnisch anspruchsvoll werden, da Multiplikationen mit Koeffizienten notwendig werden, die sehr nahe bei 1 liegen. Dies bedingt selbst bei Fliesskommadarstellung eine sehr breite Mantisse. Deshalb kann eine alternative Ausführungsform gemäß **Fig. 5** sehr vorteilhaft sein, da sie den rechentechnischen Aufwand drastisch reduziert.

Die in Fig. 5 gezeigte Ausführungsform weist einen Quadraturdetektor **50** auf, in den das Störsignal $U_{in}$ sowie zwei von einem Referenzgenerator **56** erzeugte Referenzsignale $\mathbf{U_A}$, $\mathbf{U_B}$ in zwei Signalkanälen **A**, **B** eingespeist werden. Die Frequenz dieser Referenzsignale $U_A$, $U_B$ ist ungefähr gleich der Frequenz des Störsignals $U_{in}$, wird im Register 57 gespeichert und zur Identifikation der Störfrequenz einmalig gesetzt. Die Phasen der Referenzsignale sind um 90° zueinander gedreht, wodurch in den beiden Signalkanälen A, B am Ausgang des Quadraturdetektors 50 je ein Störsignal auf einer sehr viel tieferen Frequenz um Null herum erscheint. Die beiden Signale am Ausgang des Quadraturdetektors 50 sind um 90° zueinander phasenverschoben. Das Eingangssignal $U_{in}$ wird also auf sehr tiefe Frequenzen hinunter gemischt. Die zwei Störsignale werden jeweils über einen Verstärker **51a, 51b** zu einem Tiefpassfilter **52a, 52b** einer Übertragungseinheit **59** geleitet, in dem die gewünschte Frequenzselektivität erzeugt wird. Anschließend wird das so gefilterte Signal in einem Quadraturmodulator **53** wieder auf die ursprüngliche Frequenz hinaufgemischt. Bei der in Fig. 5 gezeigten Ausführungsform besteht die Grundidee also darin, das Störsignal $U_{in}$ in einen tiefen Frequenzbereich um Null herum zu verschieben, dort mit Hilfe eines einfach zu berechnenden Tiefpassfilters 52a, 52b die gewünschte Selektivität herzustellen, und anschließend das so gefilterte Signal wieder in den ursprünglichen Frequenzbereich hinauf zu mischen. Das so entstehende Ausgangsstörsignal $U_{out}$ entspricht dann einem gefilterten Störsignal $U_{in}$, das so aussieht, als ob es in einem selektiven Bandpassfilter mit der doppelten Grenzfrequenz des Tiefpassfilters gefiltert worden wäre.

Da das Störsignal nach Durchlaufen des Quadraturdetektors 50 sehr nahe bei der Frequenz Null und in Quadraturdarstellung vorliegt, lässt sich eine Phasenkorrektur mittels eines Phasenschiebers **54** um einen konstanten Winkel sehr einfach realisieren, indem für jeden Ausgang des Phasenschiebers 54 eine Linearkombination der beiden Signale aus den Signalkanälen A ,B berechnet wird. Alternativ kann der Phasenschieber auch die beiden Referenzsignale $U_A$, $U_B$ des Quadraturmodulators 53 korrigieren, wodurch exakt dieselbe Wirkung erzielt wird. Die Phasenkorrektur verbessert die Unterdrückung der Störung bei gegebener Verstärkung, indem der Phasenfehler, welchen die Signale im Magnetfelddetektor 31, Empfängers 32 und in der Kompensationsspule 34 erfahren, bei der Zentrumsfrequenz des MSF 35 kompensiert wird.

In der in Fig. 5 gezeigten Ausführungsform ist der Ausgang des Quadraturdetektors 50 über einen Regler **58** mit dem Referenzgenerator 56 verbunden. Am Ausgang des Quadraturdetektors liegt die Summen- und die Differenzfrequenz der zwei Eingänge des Mischers (=Quadraturdetektor) vor, wobei die Differenzfrequenz die zur Frequenz Null (=DC) verschobene Störkomponente ist. Deshalb kann dieses Signal direkt zur Frequenznachführung verwendet werden. Eines der beiden im Quadraturdetektor 50 transformierten Störsignale wird in den Signalkanälen A, B erfasst und über den Regler 58 dem Referenzgenerator 56 zugeführt. Hierdurch kann die Frequenz des Referenzgenerators 56 auf die Frequenz des Störsignals eingestellt werden (= adaptiver Vorgang). Der Regler 58 umfasst einen Tiefpassfilter, in dem das obere Seitenband des im Quadraturdetektor transformierten Störsignals sowie andere Störungen entfernt werden. Die Frequenz bzw. Phase des Referenzgenerators 56 wird so nachgeführt, dass das untere Seitenband ständig null ist. Die volle Amplitude des Störsignals $U_{in}$ erscheint daher im jeweils anderen Signalkanal A, B.

Alternativ kann die Frequenz des Referenzgenerators 56 auch durch einen Phasenvergleich mit einem externen, störquellensynchronen Triggersignal geregelt werden. Diese Variante verspricht bessere Störimmunität bei kleinen, variablen Störungen.

Auch bei der in Fig. 5 gezeigten Ausführungsform der erfindungsgemäßen Vorrichtung kann bei vorhersehbaren Störungen des Feldstabilisators (etwa durch Gradientenpulse, Samplewechsel, Schaltvorgänge, Zeitmultiplex usw.) die Güte des Filterelements vorübergehend unendlich oder zumindest sehr groß gemacht werden. Dies bedeutet, dass die Verstärkungen der Verstärker 51 a, 51 b und die Grenzfrequenz der Tiefpassfilter 52a, 52b null werden. Die Tiefpassfilter 52a, 52b werden zu Integratoren mit Eingang null. Hierdurch wird die Störungskompensation fortgeführt und das verfälschte Messsignal von den Filtern ferngehalten. Ist die Störung vorüber, dann werden wieder die alten Filtergüten aktiviert und es kann ohne auf ein Einschwingen der Filter zu warten weitergearbeitet werden.

Für den Fall, dass das Verhältnis von Filterbandbreite zu Mittenfrequenz nicht sehr groß ist, wird das obere Seitenband aus dem Quadraturdetektor 50, der die ersten Mischstufe in Fig. 5 darstellt, durch die Tiefpassfilter 52a, 52b nicht genügend unterdrückt. Ein Abtast-Halteglied, das vor oder nach der Phasenkorrektur in den Signalpfad eingefügt wird und welches mit der Referenzfrequenz des Referenzgenerators 56 betrieben wird, bewirkt in diesem Fall, dass das obere, unerwünschte Seitenband genau auf das untere, erwünschte Seitenband gefaltet wird, wo es nicht mehr stört.

Die erfindungsgemäße Vorrichtung und das erfindungsgemäße Verfahren erlauben eine selektive Erfassung von periodischen Feldstörungen mit hohen Frequenzkomponenten, während ein Großteil des vorhandenen Rauschens ausgeblendet und somit das SINO erhöht wird.

**Bezugszeichenliste**

| A, B | Signalkanal |
|---|---|
| $U_{in}$ | Störsignal |
| $U_{out}$ | Ausgangsstörsignal |
| $U_A$, $U_B$ | Referenzsignal |
| BN | breitbandiges Rauschsignal, das aus dem Magnetfelddetektor stammt (= Broadband Noise) |
| RB | Regelbandbreite |
| $\Delta B_S$ | Störsignal als Feldwert |
| $\Delta B_K$ | Korrektursignal als Feldwert |
| $\Delta B_D$ | Differenzsignal als Feldwert ( $\Delta B_D = AB_S - \Delta B_K$) |
| Hold | Steuersignal, mit dem der Haltevorgang aktiviert oder deaktiviert wird. |
| 31 | Magnetfelddetektor |
| 32 | Empfänger |
| 33 | Regelverstärker zur Unterdrückung der langsamen Feldschwankungen |
| 34 | Kompensationsspule für $B_0$ |
| 35 | Multi- Selektives Filtersystem (= MSF) |
| 36 | Regelzweig mit Regelverstärker |
| 37 | Regelzweig mit MSF |
| 38 | Additionsglied |
| 40 | abstimmbarer Bandpassfilter hoher Güte |
| 41 | Regler (Frequenzdetektor) |
| 42 | Phasendetektor (Mischer) |
| 43 | Verstärker (PLL- Regelverstärker) |
| 44 | Tiefpassfilter |
| 45 | Halteregister zum Festhalten des Frequenzwertes |
| 46 | Frequenzgenerator |
| 50 | Quadraturdetektor (Down- Converter) |
| 51a/b | Verstärker, deren Verstärkung einstellbar ist |
| 52a/b | Tiefpassfilter (oder Integrator) |
| 53 | Quadraturmodulator (Up- Converter) |
| 54 | Phasenschieber |
| 56 | Referenzgenerator mit zwei in Quadratur zueinander stehenden Ausgängen |
| 57 | Halteregister für die Frequenz |
| 58 | Regler zum Nachführen der Frequenz des Referenzgenerators |
| 59 | Übertragungseinheit mit Tiefpass- Charakter, welche den Frequenzgang des selektiven Filterelementes des MSF definiert |

**Patentansprüche**

1. Vorrichtung zum Kompensieren eines Störmagnetfelds in einem Elektromagneten mit hoher Feldhomogenität insbesondere zur Stabilisierung des H0-Feldes eines MR-Messsystems, wobei das Störmagnetfeld eine periodische Feldstörung mit einer Anzahl von Störkomponenten umfasst, die jeweils eine Störfrequenz aufweisen, wobei die Vorrichtung umfasst:

   mindestens einen Magnetfelddetektor (31) zum Erfassen von Störsignalen ($U_{in}$) des Störmagnetfeldes, mindestens einen ersten und einen zweiten zueinander parallel geführten Regelzweig (36, 37) zum Bearbeiten der erfassten Störsignale ($U_{in}$), wobei die Vorrichtung so eingerichtet ist, dass die erfassten Störsignale ($U_{in}$) an den ersten und den zweiten Regelzweig (36, 37) weiter gegeben werden, wobei der erste Regelzweig (36) einen Regelverstärker (33) umfasst, und mindestens eine Kompensationsspule (34), an welche die bearbeiteten Störsignale als Ausgangsstörsignale ($U_{out}$) übertragen werden und welche zum Erzeugen eines Korrekturfelds zur Kompensation des Störmagnetfeldes eingerichtet ist,

**dadurch gekennzeichnet, dass**

der zweite Regelzweig (37) ein frequenzselektives Filtersystem (35) umfasst, welches für jede zu kompensierende Störkomponente ein frequenzselektives, als Bandpassfilter ausgebildetes Filterelement aufweist, dessen Mittelfrequenz auf die Störfrequenz der zu kompensierenden Störkomponente abstimmbar ist, und dessen Ausgang mit der mindestens einen Kompensationsspule (34) verbunden ist, wobei alle Filterelemente des Filtersystems (35) parallel zueinander geschaltet sind, und

dass der mindestens eine Magnetfelddetektor (31) zu einem NMR-Lock gehört, wobei der NMR-Lock eine NMR-Messprobe in einem HF-Resonator und einen NMR-Empfänger (32) aufweist,

2. Vorrichtung nach Anspruch 1, **dadurch gekennzeichnet, dass** zwischen den Ausgängen der Filterelemente und der mindestens einen Kompensationsspule (34) ein Additionsglied zum Addieren der Ausgangsstörsignale ($U_{out}$) der Filterelemente vorgesehen ist.

3. Vorrichtung nach einem der Ansprüche 1 oder 2, **dadurch gekennzeichnet, dass** mindestens eines der frequenzselektiven Filterelemente ein Bandpassfilter (40) zweiter Ordnung mit der komplexen Übertragungsfunktion $U_{BP}(j\omega)$ ist, wobei gilt:

$$U_{BP}(j\omega) = 1 / ( 1 + j \cdot Q \cdot \Omega ),$$

mit $\quad j \quad = \quad \sqrt{-1}$

$Q \approx \omega_0/B$
$\omega_0$ = Mittelfrequenz des Bandpassfilters
$B$ = -3db Bandbreite des Bandpassfilters
$\Omega = (\omega/\omega_0)-(\omega_0/\omega)$
$\Omega \approx 2 \cdot (\omega - \omega_0) / \omega_0$ wenn $(\omega - \omega_0) / \omega_0 \ll 1$
$\omega$ = Frequenzwert auf der Frequenzachse

4. Vorrichtung nach Anspruch 3, **dadurch gekennzeichnet, dass** das selektive Filterelement einen Regler (41) besitzt, mit dem die Mittelfrequenz des Bandpassfilters (40) auf die Frequenz eines der Störsignale ($U_{in}$) geregelt wird, wobei der Regler (41) einen in seiner Frequenz einstellbaren Frequenzgenerator (46), einen Phasendetektor (42) zur Detektion des Ausgangssignals des Frequenzgenerators (46) und des Ausgangssignals ($U_{out}$) aus dem Bandpassfilter (40), einen Verstärker (43) und einem dem Verstärker (43) nachgeschalteten Tiefpassfilter (44) umfasst, wobei das resultierende Detektionssignal aus dem Phasendetektor über den Verstärker (43) und den Tiefpassfilter (44) einem Register (45) zugeführt wird, der mit seinem Zahlenwert die Frequenz des Frequenzgenerators (46) definiert und den Ausgangswert des Reglers (41) darstellt.

5. Vorrichtung nach einem der Ansprüche 1 oder 2, **dadurch gekennzeichnet, dass** mindestens eines der frequenzselektiven Filterelemente einen Quadraturdetektor (50) umfasst, in den das Störsignal ($U_{in}$) sowie zwei Referenzsignale über zwei Signalkanäle (A ,B) eingespeist werden, wobei die Frequenz der Referenzsignale ungefähr gleich der Frequenz des Störsignals ($U_{in}$) ist, wobei die Phasen der Referenzsignale um 90° zueinander gedreht sind, und dass eine Übertragungseinheit (59) vorgesehen ist, die zu einem Quadraturmodulator (53) mit einem Additionsglied führt, in dem die in den Signalkanälen (A, B) über die Übertragungseinheit (59) zum Quadraturmodulator (53) geleiteten Störsignale addiert werden, wobei die Referenzsignale im Quadraturmodulators (53) identisch mit den Referenzsignalen im Quadraturdetektor (50) sind.

6. Vorrichtung nach Anspruch 5, **dadurch gekennzeichnet, dass** die Übertragungseinheit (59) für jeden Signalkanal (A, B) jeweils einen Verstärker (51a, 51b) und einen Tiefpassfilter (52a, 52b) umfasst.

7. Vorrichtung nach einem der Ansprüche 5 oder 6, **dadurch gekennzeichnet, dass** der Tiefpassfilter eine komplexe Übertragungsfunktion $U_{TP}(j\omega)$ besitzt, die wie folgt definiert ist:

$$U_{TP}(j\omega) = 1 / [1 + j(\omega/\omega_C)]$$

wobei $j = \sqrt{-1}$

$\omega$ =Frequenzwert auf der Frequenzachse
$\omega_C$ =Grenzfrequenz des Tiefpassfilters

**8.** Vorrichtung nach Anspruch 5, **dadurch gekennzeichnet, dass** die Übertragungseinheit (59) für jeden Signalkanal (A, B) jeweils einen Verstärker (51 a, 51 b) und einen Integrator umfasst.

**9.** Vorrichtung nach einem der Ansprüche 5 bis 8, **dadurch gekennzeichnet, dass** am Ausgang des Quadraturdetektors (50) ein Regler (58) vorgesehen ist, über den eines der beiden durch den Quadraturdetektors (50) transformierten Störsignale aus einem der beiden Signalkanäle (A, B) erfasst und einem Referenzgenerator (56) zugeführt werden kann, wobei der Regler (58) vorzugsweise einen Verstärker und einen Tiefpassfilter umfasst.

**10.** Vorrichtung nach den Ansprüchen 5 bis 9, **dadurch gekennzeichnet, dass** am Eingang des Quadraturmodulators (53) ein Phasenschieber (54) vorgesehen ist, der die beiden zueinander orthogonalen Signale in den beiden Signalkanälen (A, B) um einen bestimmten Winkel $\Delta\varphi$ verschiebt, so dass das Ausgangsstörsignal ($U_{out}$) des selektiven Filterelements zusätzlich zum Phasengang der Übertragungseinheit (59) um den konstanten Winkel $\Delta\varphi$ gegenüber dem Störsignal ($U_{in}$) verschoben ist.

**11.** Vorrichtung nach Anspruch 10, **dadurch gekennzeichnet, dass** vor oder nach dem Phasenschieber (54) ein Abtast-Halteglied geschaltet ist, welches synchron zum Referenzgenerator (56) betrieben wird.

**12.** Vorrichtung nach einem der vorhergehenden Ansprüchen, **dadurch gekennzeichnet, dass** bei mindestens einem der selektiven Filterelemente ein Steuereingang (Hold) vorgesehen ist, über den die Güte des selektiven Filterelements vorübergehend auf so hohe Werte umschaltbar ist, dass das Filterelement unempfindlich auf das Eingangssignal wird.

**13.** Verfahren zum Kompensieren eines Störmagnetfelds in einem Elektromagneten mit hoher Feldhomogenität, insbesondere zur Stabilisierung des H0-Feldes eines NMR-Messsystems, wobei das Störmagnetfeld eine periodische Feldstörung mit einer Anzahl von Störkomponenten umfasst, die jeweils eine Störfrequenz aufweisen,
wobei Störsignale ($U_{in}$) des Störmagnetfeldes mittels eines Magnetfelddetektors (31) erfasst und diese sowohl über einen ersten Regelzweig (36) mit einem Regelverstärker (33), als auch über einen zum ersten Regelzweig parallel geschalteten zweiten Regelzweig (36) an eine Kompensationsspule (34) übergeben werden, die ein Korrekturfeld zur Kompensation der Feldstörungen ($U_{in}$) erzeugt,
**dadurch gekennzeichnet,**
**dass** die Störsignale durch zweinander parallel geschaltete, frequenzselektive, als Bandpassfilter ausgebildete Filterelemente eines frequenzselektiven Filtersystems (35) geleitet werden, welches im zweiten Regelzweig (37) angeordnet ist, wobei für jede zu kompensierende Störkomponente die Mittelfrequenz eines der selektiven Filterelemente auf die Störfrequenz der zu kompensierenden Störkomponente abgestimmt wird, und
**dass** die Erfassung der Störsignale ($U_{in}$) und die Leitung der Störsignale ($U_{in}$) durch die parallel geschalteten selektiven Filterelemente innerhalb eines NMR-Locks erfolgt, der eine NMR-Messprobe in einem HF-Resonator und einen NMR-Empfänger (32) aufweist, wobei die Abstimmung der Mittelfrequenzen des Filtersystems (35) entweder einmalig oder adaptiv erfolgt, und
**dass** die Ausgangsignale ($U_{out}$) der Filterelemente vor Übergabe an die Kompensationsspule (34) entweder einzeln oder nach deren Addition und unter Einhaltung der regeltechnischen Stabilitätskriterien verstärkt und bei Bedarf Phasen korrigiert werden.

**14.** Verfahren nach Anspruch 13, **dadurch gekennzeichnet, dass** die Mittelfrequenz eines als Bandpassfilter (40) ausgebildeten selektiven Filterelements mittels eines Reglers (41) der Frequenz des Störsignals ($U_{in}$) nachgeführt wird, wobei das. Ausgangssignal eines in seiner Frequenz einstellbaren Frequenzgenerators (46), sowie das Ausgangsstörsignal ($U_{out}$) aus dem Bandpassfilter (40) in einem Phasendetektor (42) detektiert werden, und anschließend das resultierende Detektionssignal über einen Verstärker (43) und einen Tiefpassfilter (44) geleitet und einem Register (45) zugeführt wird, der mit seinem Zahlenwert die Frequenz des Frequenzgenerators (46) definiert, wobei dieser Zahlenwert dazu benutzt wird, die Mittelfrequenz des Bandpassfilters (40) auf die Frequenz des Störsignals ($U_{in}$) einzustellen.

**15.** Verfahren nach Anspruch 13, **dadurch gekennzeichnet, dass** innerhalb eines Filterelements das Störsignal ($U_{in}$)

sowie zwei Referenzsignale eines Referenzgenerators (56) in einen Quadraturdetektor (50) eingespeist werden, wobei die Frequenz dieser Referenzsignale ungefähr gleich der Frequenz des Störsignals ist und deren Phasen um 90° zueinander gedreht sind, wodurch in den beiden Signalkanälen (A, B) am Ausgang des Quadraturdetektors (50) je ein Störsignal auf einer sehr viel tieferen Frequenz und mit einer um 90° zueinander verschobenen Phase erzeugt wird, wobei diese zwei Störsignale jeweils über einen Verstärker (51a, 51b) und einen Tiefpassfilter (52a, 52b) geleitet und einem Quadraturmodulator (53) zugeführt werden, dessen Referenzsignale identisch mit denen des Quadraturdetektors sind,..

**16.** Verfahren nach den Anspruch 15, **dadurch gekennzeichnet, dass** vorzugsweise am Ausgang des Quadraturdetektors (50) eines der beiden Störsignale ($U_{in}$) in den Signalkanälen (A, B) erfasst und über einen Regler (58) dem Referenzgenerator (56) zugeführt wird, wobei die Frequenz des Referenzgenerators (56) möglichst genau auf die Frequenz des Störsignals ($U_{in}$) eingestellt wird (= adaptiver Vorgang).

**17.** Verfahren nach den Ansprüchen 15 oder 16, **dadurch gekennzeichnet, dass** die beiden orthogonalen Signale in den Signalkanälen (A, B) mittels eines Phasenschiebers (54) am Eingang des Quadraturmodulators (53) um einen bestimmten Winkel $\Delta\varphi$ verschoben werden.

**18.** Verfahren nach Anspruch 17, **dadurch gekennzeichnet, dass** vor oder nach dem Phasenschieber (54) ein Abtast-Halteglied geschaltet wird, welches synchron zum Referenzgenerator betrieben wird.

**19.** Verfahren nach einem der Ansprüche 13 bis 18, **dadurch gekennzeichnet, dass** die Güte der selektiven Filterelemente durch einen Steuereingang (Hold) vorübergehend auf so hohe Werte umgeschaltet wird, dass das Filterelement unempfindlich auf das Eingangssignal wird.

**Claims**

**1.** Device for compensating a magnetic interference field of an electromagnet with high field homogeneity, in particular for stabilizing the H0 field of an MR measuring system, wherein the magnetic interference field comprises a periodic field interference with a number of interfering components, each having an interfering frequency, the device comprising:

at least one magnetic field detector (31) for detecting interfering signals ($U_{in}$) of the magnetic interference field, at least one first and one second control branch (36, 37), which run in parallel to each other, for processing the detected interfering signals ($U_{in}$), wherein the device is designed in such a manner that the detected interfering signals ($U_{in}$) are passed on to the first and the second control branch (36, 37), wherein the first control branch (36) comprises a control amplifier (33), and
at least one compensation coil (34) to which the processed interfering signals are transferred as interfering output signals ($U_{out}$) and which is designed to generate a correction field for compensating the magnetic interference field,
**characterized in that**
the second control branch (37) comprises a frequency-selective filter system (35) which comprises for each interfering component to be compensated a frequency-selective filter element, which is designed as band pass filter, the center frequency of which can be matched to the interfering frequency of the interfering component to be compensated, and the output of which is connected to the at least one compensation coil (34), wherein all filter elements of the filter system (35) are connected in parallel to each other, and
that the at least one magnetic field detector (31) is part of an NMR lock, the NMR lock having an NMR measuring sample in an RF resonator and an NMR receiver (32).

**2.** Device according to claim 1, **characterized in that** an adding device is provided between the outputs of the filter elements and the at least one compensation coil (34) for adding the interfering output signals ($U_{out}$) of the filter elements.

**3.** Device according to claim 1 or 2, **characterized in that** at least one of the frequency-selective filter elements is a band pass filter (40) of second order with the complex transfer function $U_{BP}(j\omega)$, wherein

$$U_{BP}(j\omega) = 1/(1+j \cdot Q \cdot \Omega),$$

with

$$j = \sqrt{-1}$$

$Q \approx \omega_0/B$
$\omega_0 =$ center frequency of the band pass filter
$B = $ -3db bandwidth of the band pass filter
$\Omega = (\omega/\omega_0) - (\omega_0/\omega)$
$\Omega \approx 2 \cdot (\omega - \omega_0)/\omega_0$ when $(\omega - \omega_0)/\omega_0 \ll 1$
$\omega = $ frequency value on the frequency axis.

4. Device according to claim 3, **characterized in that** the selective filter element has a controller (41) for controlling the center frequency of the band pass filter (40) to the frequency of one of the interfering signals ($U_{in}$), wherein the controller (41) comprises a frequency generator (46) whose frequency can be adjusted, a phase detector (42) for detecting the output signal of the frequency generator (46) and the output signal ($U_{out}$) from the band pass filter (40), an amplifier (43) and a low pass filter (44) that is connected downstream of the amplifier (43), wherein the resulting detection signal from the phase detector is supplied via the amplifier (43) and the low pass filter (44) to a register (45) whose numerical value defines the frequency of the frequency generator (46) and represents the output value of the controller (41).

5. Device according to claim 1 or 2, **characterized in that** at least one of the frequency-selective filter elements comprises a quadrature detector (50) into which the interfering signal ($U_{in}$) and two reference signals are fed via two signal channels (A, B), wherein the frequency of the reference signals is approximately equal to the frequency of the interfering signal ($U_{in}$), wherein the phases of the reference signals are rotated relative to each other through 90°, and that a transfer unit (59) is provided that is guided to a quadrature modulator (53) with an adding device in which the interfering signals guided in the signal channels (A, B) to the quadrature modulator (53) via the transfer unit (59) are added, wherein the reference signals in the quadrature modulator (53) are identical to the reference signals in the quadrature detector (50).

6. Device according to claim 5, **characterized in that** the transfer unit (59) comprises one amplifier (51a, 51b) and one low pass filter (52a, 52b) for each signal channel (A, B).

7. Device according to any one of the claims 5 or 6, **characterized in that** the low pass filter has a complex transfer function $U_{TP}(j\omega)$ which is defined:

$$U_{TP}(j\omega) = 1/[1+j(\omega/\omega_C)],$$

wherein

$$j = \sqrt{-1}$$

$\omega = $ frequency value on the frequency axis
$\omega_C = $ cut-off frequency of the low pass filter.

8. Device according to claim 5, **characterized in that** the transfer unit (59) comprises one amplifier (51a, 51b) and one integrator for each signal channel (A, B).

9. Device according to any one of the claims 5 through 8, **characterized in that** a controller (58) is provided at the output of the quadrature detector (50), via which one of the two interfering signals transformed by the quadrature detector (50), of one of the two signal channels (A, B) can be detected and supplied to a reference generator (56), wherein the controller (58) preferably comprises one amplifier and one low pass filter.

10. Device according to any one of the claims 5 through 9, **characterized in that** a phase shifter (54) is provided at the input of the quadrature modulator (53), which shifts the two mutually orthogonal signals in the two signal channels (A, B) by a defined angle $\Delta\varphi$, such that the interfering output signal ($U_{out}$) of the selective filter element is shifted in addition to the phase response of the transfer unit (59) by the constant angle $\Delta\varphi$ relative to the interfering signal ($U_{in}$).

11. Device according to claim 10, **characterized in that** a sample and hold device is connected upstream or downstream of the phase shifter (54), which is operated synchronously to the reference generator (56).

12. Device according to any one of the preceding claims, **characterized in that** at least one of the selective filter elements has a control input ("Hold") via which the quality factor of the selective filter element can be temporarily switched to high values such that the filter element becomes insensitive to the input signal.

13. Method for compensating a magnetic interference field of an electromagnet with high field homogeneity, in particular for stabilizing the H0 field of an NMR measuring system, wherein the magnetic interference field comprises a periodic field interference with a number of interfering components, each having an interfering frequency,
wherein interfering signals ($U_{in}$) of the magnetic interference field are detected by a magnetic field detector (31) and are transferred to a compensation coil (34) both via a first control branch (36) comprising a control amplifier (33) and via a second control branch connected in parallel to the first control branch, the compensation coil (34) generating a correction field for compensation of the field interferences ($U_{in}$),
**characterized in that**
the interfering signals are guided through frequency-selective filter elements, which are connected in parallel to each other and are designed as band pass filter, of a frequency-selective filter system (35), which is arranged in the second control branch (37), wherein, for each interfering component to be compensated, the center frequency of one of the selective filter elements is tuned to the interfering frequency of the interfering component to be compensated, and
that the detection of the interfering signals ($U_{in}$) and the transfer of the interfering signals ($U_{in}$) through the selective filter elements, which are connected in parallel, is accomplished by means of an NMR-lock which comprises an NMR measuring sample in an RF resonator and an NMR receiver (32), wherein tuning of the center frequencies of the filter system (35) is effected either once or in an adaptive manner, and
that, prior to transfer to the compensation coil (34), the output signals ($U_{out}$) of the filter elements are either amplified individually or after addition, thereby meeting the stabilization criteria of control loops, and are phase-corrected if required.

14. Method according to claim 13, **characterized in that** the center frequency of a selective filter element designed as a band pass filter (40) is tracked by a controller (41) such that the center frequency follows the frequency of the interfering signal ($U_{in}$), wherein the output signal of a frequency generator (46) whose frequency can be adjusted, and the interfering output signal ($U_{out}$) from the band pass filter (40) are detected in a phase detector (42) and the resulting detection signal is subsequently guided via an amplifier (43) and a low pass filter (44) and supplied to a register (45) whose numerical value defines the frequency of the frequency generator (46), wherein this numerical value is used to adjust the center frequency of the band pass filter (40) to the frequency of the interfering signal ($U_{in}$).

15. Method according to claim 13, **characterized in that** within one filter element, the interfering signal ($U_{in}$) and two reference signals of a reference generator (56) are fed into a quadrature detector (50), wherein the frequency of these reference signals is approximately equal to the frequency of the interfering signal and their phases are rotated relative to each other through 90°, thereby generating one interfering signal in each of the two signal channels (A, B) at the output of the quadrature detector (50), with a much lower frequency and phase shifted by 90° relative to each other, wherein each of the two interfering signals is guided via an amplifier (51a, 51b) and a low pass filter (52a, 52b), and supplied to a quadrature modulator (53) whose reference signals are identical to those of the quadrature detector.

16. Method according to claim 15, **characterized in that** one of the two interfering signals ($U_{in}$) is detected in the signal channels (A, B) preferably at the output of the quadrature detector (50) and is supplied to the reference generator (56) via a controller (58), wherein the frequency of the reference generator (56) is preferably exactly adjusted to the frequency of the interfering signal ($U_{in}$) (adaptive process).

17. Method according to claim 15 or 16, **characterized in that** the two orthogonal signals in the signal channels (A, B) are shifted by a defined angle $\Delta\varphi$ at the input of the quadrature modulator (53) using a phase shifter (54).

18. Method according to claim 17, **characterized in that** a sample and hold device is connected upstream or downstream of the phase shifter (54), which is operated synchronously to the reference generator.

19. Method according to any one of the claims 13 through 18, **characterized in that** the quality factor of the selective filter elements is temporarily switched to high values through a control input ("Hold") such that the filter element becomes insensitive to the input signal.

**Revendications**

1. Dispositif de compensation d'un champ magnétique perturbateur dans un électroaimant à forte homogénéité de champ, en particulier de stabilisation du champ H0 d'un système de mesure RMN, le champ magnétique perturbateur comprenant une perturbation de champ périodique avec une pluralité de composantes perturbatrices qui présentent chacune une fréquence perturbatrice, le dispositif comprenant :

   au moins un détecteur de champ magnétique (31) pour détecter des signaux perturbateurs ($U_{in}$) du champ magnétique perturbateur,
   au moins une première et une deuxième branche de régulation (36, 37) menées en parallèle l'une à l'autre pour traiter les signaux perturbateurs ($U_{in}$) détectés, le dispositif étant conçu de façon que les signaux perturbateurs ($U_{in}$) détectés soient transmis à la première et à la deuxième branche de régulation (36, 37), la première branche de régulation (36) comprenant un amplificateur de réglage (33) et au moins une bobine de compensation (34) à laquelle les signaux perturbateurs traités sont transmis sous forme de signaux perturbateurs de sortie ($U_{out}$) et laquelle est conçue pour générer un champ correcteur destiné à compenser le champ magnétique perturbateur,
   **caractérisé en ce que**
   la deuxième branche de régulation (37) comprend un système de filtrage sélectif en fréquence, lequel présente, pour chacune des composante perturbatrice à compenser, un élément de filtrage sélectif en fréquence, réalisé sous la forme d'un filtre passe-bande, dont la fréquence centrale peut être accordée sur la fréquence perturbatrice de la composante perturbatrice à compenser, et dont la sortie est reliée à ladite au moins une bobine de compensation (34), tous les éléments de filtrage du système de filtrage (35) étant montés en parallèle entre eux, et que ledit au moins un détecteur de champ magnétique (31) fait partie d'un verrouillage RMN (en anglais lock), le verrouillage RMN présentant un échantillon de mesure RMN dans un résonateur HF et un récepteur RMN (32).

2. Dispositif selon la revendication 1, caractérisé en qu'un élément d'addition pour additionner les signaux perturbateurs de sortie ($U_{out}$) des éléments de filtrage est prévu entre les sorties des éléments de filtrage et ladite au moins une bobine de compensation (34).

3. Dispositif selon une des revendications 1 ou 2, caractérisé en qu'au moins un des éléments de filtrage sélectifs en fréquence est un filtre passe-bande (40) de deuxième ordre dont la fonction de transfert complexe $U_{BP}(j\omega)$ s'écrit :

$$U_{BP}(j\omega) = 1/(1 + j \cdot Q \cdot \Omega),$$

avec $\quad j \quad = \sqrt{-1}$

$$Q \quad \approx \omega_0 / B$$

$\omega_0$ = fréquence centrale du filtre passe-bande
B = largeur de bande à -3 db du filtre passe-bande

$$\Omega \quad = (\omega/\omega_0) - (\omega_0/\omega)$$

$$\Omega \quad \approx 2 \cdot (\omega - \omega_0) / \omega_0 \qquad \text{si } (\omega - \omega_0) / \omega_0 \ll 1$$

$\omega$ = valeur de la fréquence sur l'axe des fréquences

**4.** Dispositif selon la revendication 3, caractérisé en que l'élément de filtrage sélectif possède un régulateur (41) avec lequel la fréquence centrale du filtre passe-bande (40) est réglée à la fréquence d'un des signaux perturbateurs ($U_{in}$), le régulateur (41) comprenant un générateur de fréquence (46) à fréquence réglable, un détecteur de phase (42) pour détecter le signal de sortie du générateur de fréquence (46) et le signal de sortie ($U_{out}$) du filtre passe-bande (40), un amplificateur (43) et un filtre passe-bas (44) en aval de l'amplificateur (43), le signal de détection résultant provenant du détecteur de phase étant amené, via l'amplificateur (43) et le filtre passe-bas (44), à un registre (45) dont la valeur numérique définit la fréquence du générateur de fréquence (46) et représente la valeur de sortie du régulateur (41).

**5.** Dispositif selon une des revendications 1 ou 2, caractérisé en qu'au moins un des éléments de filtrage sélectifs en fréquence comprend un détecteur de quadrature (50) dans lequel le signal perturbateur ($U_{in}$) ainsi que deux signaux de référence sont injectés par deux canaux de signal (A, B), la fréquence des signaux de référence étant à peu près égale à la fréquence du signal perturbateur ($U_{in}$) et les phases des signaux de référence étant tournées de 90° l'une par rapport à l'autre,
et qu'une unité de transfert (59) est prévue, qui conduit à un modulateur en quadrature (53) avec un élément d'addition dans lequel les signaux perturbateurs transmis dans les canaux de signal (A, B) au modulateur en quadrature (53) via l'unité de transfert (59) sont additionnés, les signaux de référence dans le modulateur en quadrature (53) étant identiques aux signaux de référence dans le détecteur de quadrature (50).

**6.** Dispositif selon la revendication 5, caractérisé en que l'unité de transfert (59) comprend un amplificateur (51a, 51b) et un filtre passe-bas (52a, 52b) pour chaque canal de signal (A, B).

**7.** Dispositif selon une des revendications 5 ou 6, caractérisé en que le filtre passe-bas possède une fonction de transfert complexe $U_{TP}(j\omega)$ qui est définie comme suit :

$$U_{TP}(j\omega) = 1/[1 + j(\omega/\omega_C)],$$

avec $j \quad = \sqrt{-1}$

($\omega$ = valeur de la fréquence sur l'axe des fréquences
$\omega_C$ = fréquence limite du filtre passe-bas

**8.** Dispositif selon la revendication 5, caractérisé en que l'unité de transfert (59) comprend un amplificateur (51 a, 51 b) et un intégrateur pour chaque canal de signal (A, B).

**9.** Dispositif selon une des revendications 5 à 8, caractérisé en qu'à la sortie du détecteur de quadrature (50) est prévu un régulateur (58) par lequel un des deux signaux perturbateurs provenant d'un des deux canaux de signal (A, B) et transformés par le détecteur de quadrature (50) peut être détecté et amené à un générateur de référence (56), le régulateur (58) comprenant de préférence un amplificateur et un filtre passe-bas.

**10.** Dispositif selon les revendications 5 à 9, caractérisé en qu'à l'entrée du modulateur en quadrature (53) est prévu un déphaseur (54) qui déphase les deux signaux orthogonaux entre eux dans les deux canaux de signal (A, B) d'un angle défini $\Delta\varphi$, de sorte que le signal perturbateur de sortie ($U_{out}$) de l'élément de filtrage sélectif est déphasé, en plus de la réponse en phase de l'unité de transfert (59), de l'angle constant $\Delta\varphi$ par rapport au signal perturbateur ($U_{in}$).

**11.** Dispositif selon la revendication 10, caractérisé en qu'un échantillonneur-bloqueur, qui fonctionne de manière synchrone au générateur de référence (56), est monté avant ou après le déphaseur (54).

**12.** Dispositif selon une des revendications précédentes, caractérisé en qu'une entrée de commande (Hold) est prévue sur au moins un des éléments de filtrage sélectifs, par l'intermédiaire de laquelle la qualité de l'élément de filtrage sélectif peut être temporairement réglée à des valeurs assez élevées pour que l'élément de filtrage devienne insensible au signal d'entrée.

13. Procédé de compensation d'un champ magnétique perturbateur dans un électroaimant à forte homogénéité de champ, en particulier de stabilisation du champ H0 d'un système de mesure RMN, le champ magnétique perturbateur comprenant une perturbation de champ périodique avec une pluralité de composantes perturbatrices qui présentent chacune une fréquence perturbatrice, dans lequel des signaux perturbateurs ($U_{in}$) du champ magnétique perturbateur sont détectés au moyen d'un détecteur de champ magnétique (31) et transmis aussi bien par une première branche de régulation (36) avec un amplificateur de réglage (33) que par une deuxième branche de régulation (37) montée en parallèle avec la première branche de régulation à une bobine de compensation (34) qui génère un champ correcteur destiné à compenser les perturbations de champ ($U_{in}$),
**caractérisé en ce**
**que** les signaux perturbateurs sont transmis par des éléments de filtrage montés en parallèles entre eux, sélectifs en fréquence et réalisés sous la forme de filtres passe-bande, d'un système de filtrage sélectif en fréquence (35), lequel est disposé dans la deuxième branche de régulation (37), la fréquence centrale d'un des éléments de filtrage sélectifs étant accordée sur la fréquence perturbatrice des composantes perturbatrices pour chacune des composantes perturbatrices à compenser, et
**que** la détection des signaux perturbateurs ($U_{in}$) et la transmission des signaux perturbateurs ($U_{in}$) à travers les éléments de filtrage sélectifs montés en parallèle ont lieu dans un verrouillage RMN qui présente un échantillon de mesure RMN dans un résonateur HF et un récepteur RMN (32), l'accord des fréquences centrales du système de filtrage (35) étant effectué une seule fois ou de façon adaptative, et que les signaux de sortie ($U_{out}$) des éléments de filtrage sont amplifiés et, si nécessaire, corrigés en phase avant transfert à la bobine de compensation (34) soit isolément, soit après leur addition et en respectant les critères de stabilité selon les règles techniques.

14. Procédé selon la revendication 13, **caractérisé en ce que** la fréquence centrale d'un élément de filtrage réalisé sous la forme d'un filtre passe-bande (40) est asservie au moyen d'un régulateur (41) à la fréquence du signal perturbateur ($U_{in}$), le signal de sortie d'un générateur de fréquence (46) à fréquence réglable ainsi que le signal perturbateur de sortie ($U_{out}$) du filtre passe-bande (40) étant détectés dans un détecteur de phase (42), et le signal de détection résultant étant ensuite transmis via un amplificateur (43) et un filtre passe-bas (44) et amené à un registre (45) dont la valeur numérique définit la fréquence du générateur de fréquence (46), cette valeur numérique étant utilisée pour régler la fréquence centrale du filtre passe-bande (40) à la fréquence du signal perturbateur ($U_{in}$).

15. Procédé selon la revendication 13, **caractérisé en ce qu'**à l'intérieur d'un élément de filtrage, le signal perturbateur ($U_{in}$) ainsi que deux signaux de référence d'un générateur de référence (56) sont injectés dans un détecteur de quadrature (50), la fréquence de ces signaux de référence étant à peu près égale à la fréquence du signal perturbateur et leurs phases étant tournées de 90° l'une par rapport à l'autre, de sorte que des signaux perturbateurs à une fréquence beaucoup plus basse et déphasés de 90° l'un par rapport à l'autre sont générés sur les deux canaux de signal (A, B) à la sortie du détecteur de quadrature (50), ces deux signaux perturbateurs étant transmis chacun via un amplificateur (51a, 51b) et un filtre passe-bas (52a, 52b) et amenés à un modulateur en quadrature (53) dont les signaux de référence sont identiques à ceux du détecteur de quadrature.

16. Procédé selon la revendication 15, **caractérisé en ce qu'**un des deux signaux perturbateurs ($U_{in}$) est détecté dans les canaux de signal (A, B), de préférence à la sortie du détecteur de quadrature (50), et amenés au générateur de référence (56) via un régulateur (58), la fréquence du générateur de référence (56) étant réglée le plus précisément possible à la fréquence du signal perturbateur ($U_{in}$) (= processus adaptatif).

17. Procédé selon les revendications 15 ou 16, **caractérisé en ce que** les deux signaux orthogonaux dans les canaux de signal (A, B) sont déphasés d'un angle défini $\Delta\varphi$ au moyen d'un déphaseur (54) à l'entrée du modulateur en quadrature (53).

18. Procédé selon la revendication 17, **caractérisé en ce qu'**un échantillonneur-bloqueur, qui fonctionne de manière synchrone au générateur de référence, est monté avant ou après le déphaseur (54).

19. Procédé selon une des revendications 13 à 18, **caractérisé en ce que** la qualité des éléments de filtrage sélectifs peut être temporairement réglée par une entrée de commande (Hold) à des valeurs assez élevées pour que l'élément de filtrage devienne insensible au signal d'entrée.

**Fig. 1**

Fig. 2a

$f_S$

BN

f

Fig. 2b

1

RB

f

Fig. 3a

BN

$f_S$

f

Fig. 3b

35

f

Fig. 3c

35

BN

f

Hold

35

$U_{in}$

$U_{out}$

40

44

43

42

DDS

45

46

41

**Fig. 4**

Fig. 5

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- DE 29536390 A1
- DE 3628161 A1
- US 5191287 A1
- US 4788502 A1
- US 5302899 A1
- JP 08194045 B